# EUROPÄISCHE PATENTSCHRIFT

(11) **EP 1 184 871 B1**
(45) Veröffentlichungstag und Bekanntmachung des Hinweises auf die Patenterteilung: **07.03.2007**
(21) Anmeldenummer: 01119039.4
(22) Anmeldetag: 07.08.2001
(51) Int. Cl.: G11C 11/16

(54) **MRAM-Anordnung**
MRAM memory device
Dispositif de mémoire MRAM

(30) Priorität: 23.08.2000 DE 10041378
(43) Veröffentlichungstag der Anmeldung: 06.03.2002
(73) Patentinhaber: Qimonda AG, 81739 München (DE)
(72) Erfinder: Gogl, Dietmar, 12524 Fishkill, NY (US); Schloesser, Till, 01109 Dresden (DE)
(74) Vertreter: Müller - Hoffmann & Partner

(56) Entgegenhaltungen:
- US-A- 5 189 594
- US-A- 5 699 293

## Beschreibung

Die vorliegende Erfindung betrifft eine MRAM-Anordnung mit einer Vielzahl von TMR-Speicherzellen (TMR = Tunnel-Magnetwiderstand), die in einem Speicherzellenfeld an ihrem einen Ende mit Bitleitungen verbunden und an ihrem dem einen Ende gegenüberliegenden anderen Ende an Wortleitungen angeschlossen sind.

Eine MRAM-Anordnung beruht bekanntlich auf ferromagnetischer Speicherung mit Hilfe des TMR-Effektes: zwischen einer Wortleitung und einer Bitleitung, die sich senkrecht kreuzen, liegt eine Speicherzelle aus einem Schichtstapel mit einer weichmagnetischen Schicht, einer Tunnelwiderstandsschicht und einer hartmagnetischen Schicht. Die Magnetisierungsrichtung der hartmagnetischen Schicht ist vorgegeben, während die Magnetisierungsrichtung der weichmagnetischen Schicht einstellbar ist, indem durch die Wortleitung und die Bitleitung entsprechende Ströme in bestimmten Richtungen geschickt werden. Damit kann die weichmagnetische Schicht parallel oder antiparallel zur hartmagnetischen Schicht magnetisiert sein. Bei paralleler Magnetisierung ist der Widerstandswert des Schichtstapels niedriger als bei antiparalleler Magnetisierung, was als Zustand "0" bzw. "1" oder umgekehrt ausgewertet werden kann.

Für einen MRAM werden bisher im wesentlichen zwei sich grundsätzlich voneinander unterscheidende Architekturen vorgeschlagen:
Bei einem sogenannten "Crosspoint"-Aufbau liegen die einzelnen TMR-Speicherzellen direkt zwischen sich kreuzenden und Bit- bzw. Wortleitungen bildenden Leiterbahnen. Bei diesem Aufbau werden für die einzelnen Speicherzellen keine Halbleiterbauelemente und insbesondere Transistoren benötigt, so daß ohne weiteres mehrere Lagen derartiger Speicherzellen in übereinandergestapelten Speicherzellenfeldern vorgesehen werden können. Damit sind für einen MRAM sehr hohe Integrationsdichten erreichbar, die in der Größenordnung von "4 F²/n" liegen, wobei n die Anzahl der einzelnen, übereinander gestapelten Lagen von Speicherzellenfeldern ist und "F" die Fläche der kleinstmöglichen Struktur der verwendeten Technologie bedeutet.

Bei einem derartigen "Crosspoint"-Aufbau fließen zwangsläufig parasitäre Ströme über nicht ausgewählte Speicherzellen. Daher müssen in großen Speicherzellenfeldern die einzelnen TMR-Speicherzellen mit einem sehr hohen Widerstand ausgestattet werden, um diese parasitären Ströme gering halten zu können. Infolge des hohen Widerstandes der einzelnen TMR-Speicherzellen ist der Lesevorgang relativ langsam.

Bei der anderen Architektur, bei der Transistorzellen vorgesehen sind, ist jedem einzelnen TMR-Element mit dem obigen Schichtstapel zusätzlich ein Schalttransistor zugeordnet (vgl. hierzu M. Durlam et al. "Nonvolatile RAM based on Magnetic Tunnel Junction Elements"). Bei einem MRAM mit Speicherzellen aus solchen TMR-Elementen mit Schalttransistoren sind parasitäre Ströme praktisch ausgeschlossen. Dadurch können die Speicherzellen auch in großen Speicherzellenfeldern mit einem geringen Widerstand des TMR-Elementes versehen werden. Auch ist das Leseverfahren einfacher, so daß ein schnellerer Zugriff als bei einem "Crosspoint"-Aufbau möglich ist.

Nachteilhaft an einem Aufbau mit Transistor-Speicherzellen sind aber die erheblich größeren Abmessungen, die wenigstens "8 F²" betragen und darüber liegen, wobei zudem keine Stapelung vorgenommen werden kann, da für jede Speicherzelle in einem Speicherzellenfeld ein Transistor und damit eine Silizium-Oberfläche benötigt wird.

Es ist daher Aufgabe der vorliegenden Erfindung, eine MRAM-Anordnung zu schaffen, bei der die Vorteile eines "Cross-point"-Aufbaues mit den Vorteilen von Transistor-Speicherzellen möglichst weitgehend gemeinsam vorliegen.

Diese Aufgabe wird bei einer MRAM-Anordnung der eingangs genannten Art erfindungsgemäß dadurch gelöst, daß die anderen Enden von jeweils mit derselben Bitleitung verbundenen TMR-Speicherzellen in wenigstens zwei TMR-Speicherzellen umfassenden Gruppen mit einem Schalttransistor verbunden sind, dessen Gate an die entsprechende Wortleitung angeschlossen ist und dessen Source bzw. Drain geerdet ist, und dass der Widerstand einer TMR-Speicherzelle ungefähr dem Gesamtwiderstand aus dem Schalttransistor und zugeordneten Leitungswiderständen entspricht.

Bei der erfindungsgemäßen MRAM-Anordnung wird so in vollkommener Abkehr von dem bisherigen Aufbau mit Transistor-Speicherzellen nicht mehr jeder TMR-Element ein Schalttransistor zugeordnet. Vielmehr werden bei der erfindungsgemäßen MRAM-Anordnung mehrere TMR-Speicherzellen längs einer Bitleitung zu einer Gruppe zusammengefaßt, wobei dieser Gruppe dann ein Schalttransistor zugewiesen ist.

Durch die Zuordnung von nur einem Schalttransistor zu mehreren TMR-Speicherzellen, beispielsweise drei TMR-Speicherzellen, kann der für die Transistoren erforderliche Platzbedarf erheblich reduziert werden, so daß die bei der erfindungsgemäßen MRAM-Anordnung verwendete Architektur eine wesentliche Erhöhung der Packungsdichte im Speicherzellenfeld erlaubt.

Die erfindungsgemäße MRAM-Anordnung ermöglicht auch ein platzsparendes Layout der TMR-Speicherzellen und des diesen zugeordneten Transistors, indem beispielsweise unter drei TMR-Speicherzellen ein Schalttransistor angeordnet wird.

Selbstverständlich können aber auch mehr als drei TMR-Speicherzellen für einen Schalttransistor vorgesehen werden. Weiterhin ist es auch möglich, beispielsweise nur zwei TMR-Speicherzellen einem Schalttransistor zuzuweisen. Schließlich kann auch eine solche Aufteilung der Speicherzellen eines Speicherzellenfeldes auf Schalttransistoren vorgenommen werden, daß ausnahmsweise auch Zuordnungen von nur einer Speicherzelle zu einem Schalttransistor vorliegen können. Wesentlich an der vorliegenden Erfindung ist also, daß in einem Speicherzellenfeld mit einer Vielzahl von Speicherzellen diesen Schalttransistoren derart zugeordnet sind, daß für eine Mehrzahl von Speicherzellen dieses Speicherzellenfeldes jeweils ein Schalttransistor mehreren Speicherzellen einer jeweiligen Bitleitung zugewiesen ist.

Ein schnelles Auslesen von MRAM-Speicherzellen mit Transistoren ist dann gewährleistet, wenn eine möglichst große absolute Differenz der beim Lesen der beiden Zustände erhaltenen Ströme vorliegt. Das heißt, die Stromdifferenz zwischen einem parallelen Zustand und einem antiparallelen Zustand der beiden magnetischen Schichten sollte möglichst groß sein. Um dies zu erreichen, ist der Widerstand der TMR-Speicherzelle bzw. des TMR-Elementes ungefähr gleich zu dem in Reihe zu diesem Widerstand liegenden Gesamtwiderstand aus dem Schalttransistor und dem Widerstand der Leitungen. Je kleiner dann der Serienwiderstand aus dem Widerstand der TMR-Speicherzelle und obigem Gesamtwiderstand ist, desto größer wird das beim Lesen erhaltene absolute Lesesignal.

Bei der erfindungsgemäßen MRAM-Anordnung werden, wie bereits oben erläutert wurde, also n TMR-Speicherelemente längs einer Bitleitung parallel geschaltet und an ihrem anderen Ende mit dem Schalttransistor verbunden. Dies hat an sich den Nachteil, daß der durch die n parallel zueinander liegenden TMR-Speicherelemente fließende Signalstrom um diesen Faktor n jeweils verringert bzw. "verdünnt" wird. Dieser Nachteil läßt sich aber wenigstens teilweise dadurch kompensieren, daß unter einer Layout-Fläche für nur drei TMR-Speicherelemente ohne weiteres ein Schalttransistor Platz findet, so daß bei einer Zuordnung von drei TMR-Speicherzellen zu einem Schalttransistor ein relativ niedriger Serienwiderstand gewährleistet werden kann.

Werden so drei TMR-Speicherzellen mit einem Schalttransistor zusammengeschaltet, so nimmt eine damit erhaltene Gruppe aus drei Speicherzellen eine Fläche von etwa "15 ... 16 F²" ein, was einem Flächenbedarf von "5 ... 5,3 F²" für jede Speicherzelle entspricht. Dieser Wert ist erheblich niedriger als ein Wert von "7 ... 8 F²", der bei einem Aufbau mit Speicherzellen aus jeweils einem TMR-Element und einem Transistor erforderlich ist. Auch kann bei einem solchen Layout mit einem Schalttransistor für drei TMR-Speicherzellen gegenüber einem Aufbau mit einem Transistor für jede Speicherzelle eine dreifache Transistorweite eingesetzt werden, so daß bei entsprechender Einstellung der Widerstände der TMR-Elemente die gleiche absolute Signaldifferenz zwischen den beiden Zuständen erreichbar ist.

Nachfolgend wird die Erfindung anhand der Zeichnungen näher erläutert. Es zeigen:
- Fig. 1: ein schematisches Schaltbild zur Erläuterung der erfindungsgemäßen MRAM-Anordnung,
- Fig. 2a bis 2d: ein Layout für eine Gruppe, bei der drei Speicherzellen mit jeweils einem Schalttransistor versehen sind und
- Fig. 3a bis 3c: verschiedene Schritte zur Erläuterung der Herstellung der erfindungsgemäßen MRAM-Anordnung.

In den Figuren werden einander entsprechende Bauteile jeweils mit den gleichen Bezugszeichen versehen.

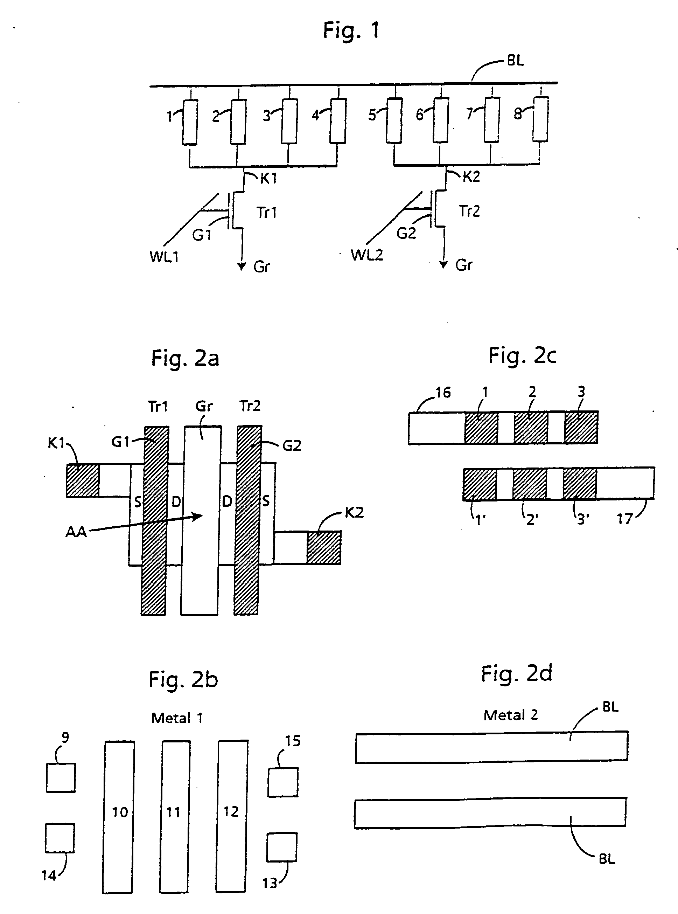

Fig. 1 zeigt eine MRAM-Anordnung mit einer Bitleitung BL und diese im wesentlichen senkrecht im Abstand kreuzenden Wortleitungen WL1 und WL2. Zwischen der Bitleitung BL und den Wortleitungen WL1 liegen TMR-Speicherzellen 1, 2, 3 und 4, und zwischen der Bitleitung BL und der Wortleitung WL2 liegen TMR-Speicherzellen 5, 6, 7 und 8. Diese Speicherzellen sind jeweils in der üblichen, eingangs erläuterten Weise aus einer weichmagnetischen Schicht, einer Tunnelwiderstandsschicht und einer hartmagnetischen Schicht aufgebaut.

Die der Bitleitung BL gegenüberliegenden Enden der TMR-Speicherzellen 1 bis 4 sind mit Drain bzw. Source eines Schalttransistors Tr1 verbunden, während die der Bitleitung BL gegenüberliegenden Enden der Schalttransistoren 5 bis 8 an Drain bzw. Source eines Schalttransistors Tr2 angeschlossen sind. Gate des Schalttransistors Tr1 ist an die Wortleitung WL1 angeschlossen, und Gate des Schalttransistors Tr2 ist an die Wortleitung WL2 angeschlossen. Source bzw. Drain der Schalttransistoren Tr1 und Tr2 sind geerdet bzw. liegen an Ground. In dem Ausführungsbeispiel von Fig. 1 sind jeweils vier TMR-Speicherzellen 1 bis 4 bzw. 5 bis 8 jeweils einem Schalttransistor Tr1 bzw. Tr2 zugeordnet. Anstelle dieser vier TMR-Speicherzellen können auch zwei oder drei Speicherzellen oder mehr als vier Speicherzellen einem Schalttransistor zugewiesen sein.

Bei einem Lesevorgang wird an die Bitleitung BL eine bestimmte Spannung von 1 bis 2 V angelegt. Die Transistoren aller Wortleitungen bis auf die Transistoren einer bestimmten Wortleitung sind dabei gesperrt. Es sei angenommen, daß im vorliegenden Beispiel die Transistoren der Wortleitung WL1 leiten, d.h., im vorliegenden Beispiel soll der Schalttransistor Tr1 durchgeschaltet sein.

Ist nun beispielsweise die TMR-Speicherzelle 2 in einem niederohmigen Zustand (parallele Magnetisierung der beiden magnetischen Schichten), während die übrigen TMR-Speicherzellen 1, 3 und 4 in einem hochohmigen Zustand (antiparallele Magnetisierung der magnetischen Schichten) sind, so wird auf der Wortleitung WL1 ein entsprechendes Signal erhalten, das sich von dem Signal unterscheidet, das auf der Wortleitung WL1 anliegt, wenn alle TMR-Speicherzellen 1 - 4 im hochohmigen Zustand sind.

Um zu bestimmen, welche der Speicherzellen 1 bis 4 im niederohmigen Zustand ist, erfolgt - ähnlich wie bei einem DRAM - ein Rückschreiben der Information in die jeweiligen Speicherzellen und ein Vergleich mit dem zuvor erhaltenen Signal. Auf diese Weise kann festgestellt werden, daß die TMR-Speicherzelle 2 im niederohmigen Zustand ist, während die Speicherzellen 1, 3 und 4 den hochohmigen Zustand beinhalten. Mit anderen Worten, es kann beispielsweise eine "1" der Speicherzelle 2 zugeordnet werden, während die Speicherzellen 1, 3 und 4 eine Information "0" enthalten.

Die Fig. 2a bis 2d zeigen das Layout für die MRAM-Anordnung von Fig. 1.

Wie in Fig. 2a gezeigt ist, sind in einem aktiven Bereich AA eines Silizium-Halbleiterkörpers Source S und Drain D von jeweils den beiden Transistoren Tr1 und Tr2 vorgesehen und durch eine entsprechende Diffusion mit einem Kontakt K1 bzw. K2 verbunden. Der Transistor Tr1 hat eine Gateelektrode G1, und der Transistor Tr2 weist eine Gateelektrode G2 auf. Die Gateelektrode G1 ist mit der Wortleitung WL1 verbunden, während die Gateelektrode G2 an die Wortleitung WL2 angeschlossen ist. Außerdem ist in Fig. 2a noch eine Ground-Elektrode Gr der beiden Transistoren Tr1 und Tr2 gezeigt.

Fig. 2b zeigt die erste Metallisierungsebene (Metal 1) für die Anordnung von Fig. 2a mit entsprechenden Metallisierungen 9 (für den Kontakt K1), 10 (für Drain D des Transistors Tr1), 11 (für Ground Gr der beiden Transistoren Tr1 und Tr2), 12 (für Drain des Transistors Tr2) und 13 (für den Kontakt K2 des Transistors Tr2). Metallisierungen 14 und 15 sind benachbarten Gruppen von Transistoren bzw. TMR-Speicherzellen zugeordnet.

Wie in Fig. 2c gezeigt ist, befinden sich auf der ersten Metallisierungsebene ("Metal 1") von Fig. 2b Streifenanordnungen ("Straps") 16, 17 mit jeweils TMR-Speicherzellen 1, 2 und 3 bzw. 1', 2' und 3'. Diese TMR-Speicherzellen 1 bis 3 bzw. 1' bis 3' sind, wie in Fig. 2d gezeigt ist, der Bitleitung BL zugeordnet, die in einer Ebene oberhalb der zweiten Metallisierungsebene ("Metal 2") verläuft. Dies ist in Fig. 2d dadurch angedeutet, daß beide Streifen der zweiten Metallisierungsebene mit dem Bezugszeichen BL versehen sind.

Es sei angemerkt, daß im Ausführungsbeispiel der Fig. 2a bis 2d jedem Transistor Tr1 bzw. Tr2 nur drei TMR-Speicherzellen zugeordnet sind, während im Ausführungsbeispiel von Fig. 1 jeder Transistor Tr1 bzw. Tr2 jeweils vier TMR-Speicherzellen 1 bis 4 bzw. 5 bis 8 hat.

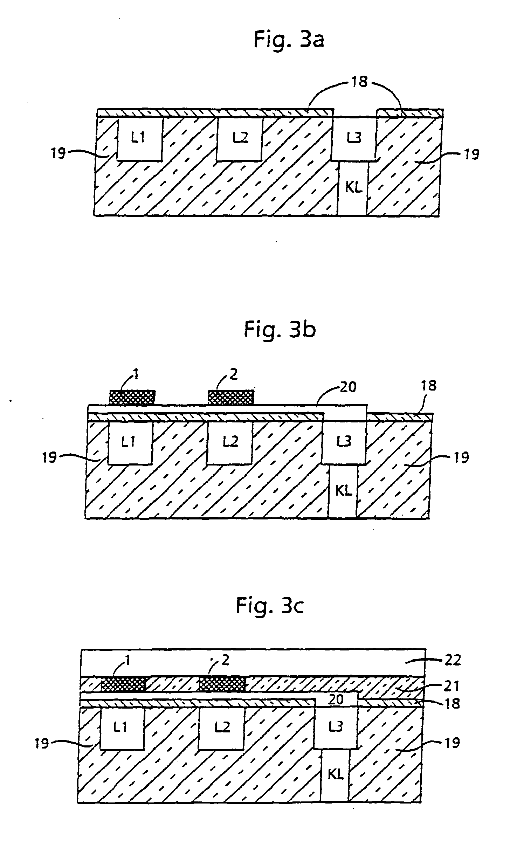

Die Fig. 3a bis 3c veranschaulichen in schematischen Schnitten ein Verfahren zum Herstellen von TMR-Speicherzellen bzw. - Elementen.

Auf einem Halbleiterkörper (nicht gezeigt) mit einem CMOS-Transistor als Schalttransistor und einer ersten Metallisierungsebene ("Metal 1"; vgl. Fig. 2b) befinden sich Siliziumdioxidschichten 18, 19 in denen Leiterbahnen L1, L2 und L3 vorgesehen sind. Die Leiterbahnen L1 und L2 dienen als Leitungen zum Beschreiben von zwei TMR-Speicherzellen, beispielsweise der Speicherzellen 1 und 2. Die Leiterbahn L3 ist in einem Kontaktloch KL, das mit einer entsprechenden Metallisierung versehen ist, beispielsweise mit dem Kontakt K1 des darunterliegenden und im Silizium-Halbleiterkörper eingebetteten Transistors Tr1 verbunden.

Weiterhin wird die Leiterbahn L3, wie in Fig. 3b gezeigt ist, über eine Metallisierung 20 mit TMR-Elementen 1 und 2 verbunden. Die Metallisierung 20 und die TMR-Elemente bzw. -Speicherzellen 1 und 2 werden in üblicher Weise photolithographisch und durch Ätzen hergestellt.

Nach Auftragen einer weiteren Siliziumdioxidschicht 21 und der zweiten Metallisierungsebene durch eine Metallisierung 22 wird schließlich die in Fig. 3c gezeigte Anordnung erhalten.

Die Speicherzellen 1 und 2 werden beschrieben, indem an die Metallisierungen L1 bzw. L2 und an die Metallisierung 22 entsprechende Signale gelegt werden, die eine antiparallele bzw. parallele Magnetisierung der beiden magnetischen Schichten der Speicherzellen 1 und 2 bewirken.

## Patentansprüche

1. MRAM-Anordnung mit einer Vielzahl von TMR-Speicherzellen (1 bis 8), die in einem Speicherzellenfeld an ihrem einen Ende mit Bitleitungen (BL) verbunden und an ihrem dem einen Ende gegenüberliegenden anderen Ende an Wortleitungen (WL1, WL2) angeschlossen sind,
**dadurch gekennzeichnet, daß**
- die anderen Enden von jeweils mit derselben Bitleitung (BL) verbundenen TMR-Speicherzellen (1 bis 8) in wenigstens zwei TMR-Speicherzellen (1 bis 4 bzw. 5 bis 8) umfassenden Gruppen mit Drain bzw. Source eines Schalttransistors (Tr1, Tr2) verbunden sind, dessen Gate (G1, G2) an die entsprechende Wortleitung (W1 bzw. W2) angeschlossen ist und dessen Source bzw. Drain geerdet ist, und
- der Widerstand einer TMR-Speicherzelle (1 bis 8) ungefähr dem Gesamtwiderstand aus dem Schalttransistor (Tr1, Tr2) und zugeordneten Leitungswiderständen entspricht.

2. MRAM-Anordnung nach Anspruch 1,
**dadurch gekennzeichnet, daß**
drei TMR-Speicherzellen (1 bis 3; 5 bis 8) ein Schalttransistor (Tr1; Tr2) zugeordnet ist.

3. MRAM-Anordnung nach Anspruch 1 oder 2,
**dadurch gekennzeichnet, daß**
der Schalttransistor (Tr1; Tr2) unterhalb der TMR-Speicherzelle (1 bis 8) vorgesehen ist.

4. MRAM-Anordnung nach einem der Ansprüche 1 bis 3,
**dadurch gekennzeichnet, daß**
die TMR-Speicherzellen (1 bis 8) zwischen zwei Metallisierungsebenen ("Metal 1", "Metal 2") gelegen sind.

5. MRAM-Anordnung nach einem der Ansprüche 1 bis 4,
**dadurch gekennzeichnet, daß**
die Ground-Elektroden (Gr) von jeweils zwei benachbarten Transistoren (Tr1, Tr2) zu einer Elektrode zusammengefaßt sind.

## Claims

1. MRAM configuration having a multiplicity of TMR memory cells (1 to 8) that, in a memory cell field, are connected at their one end with bit lines (BL) and are connected at their other end, situated opposite the one end, to word lines (WL1, WL2),
**characterized in that**
- the other ends of TMR memory cells (1 to 8) connected respectively with the same bit line (BL), in groups containing at least two TMR memory cells (1 to 4 and 5 to 8), are connected with the drain or source of a switching transistor (Tr1, Tr2) whose gate (G1, G2) is connected to the corresponding word line (W1 or W2) and whose source or drain is earthed, and
- the resistance of a TMR memory cell (1 to 8) approximately corresponds to the overall resistance composed of the switching transistor (Tr1, Tr2) and allocated line resistances.

2. MRAM configuration according to Claim 1,
**characterized in that**
a switching transistor (Tr1; Tr2) is allocated to three TMR memory cells (1 to 3; 5 to 8).

3. MRAM configuration according to Claim 1 or 2,
**characterized in that**
the switching transistor (Tr1; Tr2) is provided underneath the TMR memory cell (1 to 8).

4. MRAM configuration according to one of Claims 1 to 3,
**characterized in that**
the TMR memory cells (1 to 8) are laid between two metallization planes ("Metal 1", "Metal 2").

5. MRAM configuration according to one of Claims 1 to 4,
**characterized in that**
the earth electrodes (Gr) of two respective adjacent transistors (Tr1, Tr2) are combined to form one electrode.

## Revendications

1. Dispositif MRAM ayant une pluralité de cellules de mémoire TMR (1 à 8) qui sont reliées dans un champ de cellules de mémoire, à l'une de leurs extrémités, à des lignes (BL) de bit et qui sont raccordées, à leur autre extrémité opposée à la une extrémité, à des lignes (WL1, WL2) de mot,
**caractérisé en ce que**
- les autres extrémités de cellules de mémoire TMR (1 à 8), reliées respectivement à la même ligne (BL) de bit, sont reliées en des groupes comprenant au moins deux cellules de mémoire TMR (1 à 4 et 5 à 8) à un drain et une source d'un transistor (Tr1, Tr2) de commutation, dont la grille (G1, G2) est raccordée à la ligne (W1 et W2) de mot correspondante et dont la source ou le drain est mis à la terre, et
- la résistance d'une cellule de mémoire TMR (1 à 8) correspond à peu près à la résistance totale constituée du transistor (Tr1, Tr2) de commutation et des résistances de lignes associées.

2. Dispositif MRAM suivant la revendication 1,
**caractérisé en ce qu'**un transistor (Tr1 ; Tr2) de commutation est associé à trois cellules de mémoire TMR (1 à 3 ; 5 à 8).

3. Dispositif MRAM suivant la revendication 1 ou 2,
**caractérisé en ce que** le transistor (Tr1 ; Tr2) de commutation est prévu en dessous de la cellule de mémoire TMR (1 à 8).

4. Dispositif MRAM suivant l'une des revendications 1 à 3,
**caractérisé en ce que** les cellules de mémoire TMR (1 à 8) sont mises entre deux plans de métallisation ("métal 1", "Métal 2").

5. Dispositif MRAM suivant l'une des revendications 1 à 4,
**caractérisé en ce que** les électrodes (Gr) de terre de respectivement deux transistors (Tr1, Tr2) voisins sont rassemblées en une électrode.
